# EUROPÄISCHE PATENTSCHRIFT

(11) **EP 2 821 709 B1**
(45) Veröffentlichungstag und Bekanntmachung des Hinweises auf die Patenterteilung: **19.04.2017**
(21) Anmeldenummer: 14173462.4
(22) Anmeldetag: 23.06.2014
(51) Int. Cl.: F24C 7/08, G05G 1/08

(54) **Bedienvorrichtung mit einem Bedienelement mit einem Haftelement an der Bedienelementunterseite sowie Haushaltsgerät mit einer derartigen Bedienvorrichtung**
Operating device with an operating element with an adhesive element on the bottom of the operating element and household device with such an operating device
Dispositif de commande doté d'un élément de commande ayant un élément adhésif sur le côté inférieur de l'élément de commande et appareil ménager doté d'un tel dispositif de commande

(30) Priorität: 01.07.2013 DE 102013212815
(43) Veröffentlichungstag der Anmeldung: 07.01.2015
(73) Patentinhaber: BSH Hausgeräte GmbH, 81739 München (DE)
(72) Erfinder: Huber, Johann, 83334 Inzell (DE); Maier, Thomas, 84518 Garching a.d. Alz (DE); Vormann, Ingo, 83413 Fridolfing (DE); Wurnitsch, Ernst, 6382 Kirchdorf in Tirol (AT)

(56) Entgegenhaltungen:
- DE-A1- 10 212 953
- DE-A1- 10 255 676
- US-A1- 2010 253 653

## Beschreibung

Die Erfindung betrifft eine Bedienvorrichtung für ein Haushaltsgerät mit einem Bedienelement, welches auf einer Bedienelementaufnahme des mit der Bedienvorrichtung steuerbaren Haushaltsgeräts mittels Magnetkraft haltbar und relativ zur Bedienelementaufnahme bewegbar und von dort abnehmbar positionierbar ist. Das Bedienelement umfasst einen Bedienelementsockel und eine den Bedienelementsockel von oben zumindest bereichsweise abdeckende Bedienelementkappe. Die Bedienelementkappe ist mit dem Bedienelementsockel verbunden und zur Einstellung von Betriebsbedingungen des Haushaltsgeräts relativ zum Bedienelementsockel drehbar.

Derartige Bedienvorrichtungen sind bekannt. So zeigt beispielsweise die DE 102 12 953 A1 eine Bedienvorrichtung für ein Elektrogerät, bei der eine Bedieneinheit eine scheibenförmige Lagervorrichtung sowie einen daran drehbar gelagerten Drehknebel aufweist. Mittels Haltemagneten ist die Bedieneinheit an einer Abdeckung, die eine Kochfeldplatte ist, abnehmbar befestigt. In einem Zwischenraum zwischen dem Drehknebel und der Lagervorrichtung ist an dem Drehknebel ein metallischer Polstern angeordnet. An Enden des Polsterns sind Winkelabsätze ausgebildet, wobei dazu korrespondierend unterhalb der Abdeckung Hall-Sensoren angeordnet sind. Die Enden des Polsterns sind magnetisch aktiv oder mit kleinen Magneten besetzt, so dass bei einem Bewegen über die Hall-Sensoren hinweg ein Signal ausgelöst wird. Die Hall-Sensoren sind wiederum mit einer Steuerung verbunden, so dass das durch die Drehung erzeugte Signal ausgewertet und die zugeordnete Betriebsbedingungseinstellung erfolgen kann.

Bei einer derartigen Ausgestaltung kann die Drehstellungseinstellung und Erkennung toleranzbehaftet sein, so dass es gegebenenfalls zu Fehlinterpretationen der Drehstellung kommen kann und dadurch unerwünschte Betriebsbedingungseinstellungen auftreten können.

Darüber hinaus ist es im Stand der Technik vorgesehen, dass die Lagervorrichtung mit ihrer Unterseite auf der Oberseite der Kochfeldplatte aus Glaskeramik aufsitzt und nur durch einen Magneten von der Lagervorrichtung einerseits und einem damit wechselwirkenden weiteren Magneten unter der Kochfeldplatte andererseits gehalten ist. Gerade bei diesen Ausgestaltungen, bei denen die Lagervorrichtung an ihrer Unterseite eben ausgebildet ist und auf eine ebene Fläche auf der Abdeckung und somit der Kochfeldplatte positioniert wird, kann beim Betätigen des Drehknebels ein unerwünschtes Verrutschen auftreten, so dass auch hier Fehler bei der Detektion und der Betriebsbedingungseinstellung auftreten können.

Es ist Aufgabe der vorliegenden Erfindung, eine Bedienvorrichtung und ein Haushaltsgerät zu schaffen, bei welcher beziehungsweise bei welchem die Drehstellungseinstellung bei einem Bedienelement mit einem Bedienelementsockel und einer relativ dazu drehbaren Bedienelementkappe präzisiert und unerwünschte Bewegungen des Bedienelements bei der Bewegung der Bedienelementkappe verhindert sind.

Diese Aufgabe wird durch eine Bedienvorrichtung und ein Haushaltsgerät gemäß den unabhängigen Ansprüchen gelöst.

Eine erfindungsgemäße Bedienvorrichtung für ein Haushaltsgerät umfasst ein Bedienelement, welches einen Bedienelementsockel und eine den Bedienelementsockel von oben zumindest bereichsweise abdeckende Bedienelementkappe aufweist. Die Bedienelementkappe ist mit dem Bedienelementsockel verbunden und zur Einstellung von Betriebsbedingungen des Haushaltsgeräts relativ zum Bedienelementsockel drehbar.

Insbesondere ist vorgesehen, dass das Bedienelement auf einer Bedienelementaufnahme der Bedienvorrichtung mittels Magnetkraft haltbar und relativ zur Bedienelementaufnahme bewegbar und von dort abnehmbar positionierbar ist.

Ein wesentlicher Gedanke der Erfindung ist darin zu sehen, dass an einer im auf der Bedienelementaufnahme positionierten Zustand des Bedienelements der Bedienelementaufnahme zugewandten Unterseite des Bedienelementsockels zumindest ein Haftelement ausgebildet ist, dessen Material einen größeren Reibungswiderstand bzw. Reibungskoeffizienten aufweist, als die Unterseite. Dadurch ist die Drehstellungseinstellung bei einem Bedienelement mit einem Bedienelementsockel und einer relativ dazu drehbaren Bedienelementkappe präzisiert und unerwünschte Bewegungen des Bedienelements bei der Bewegung der Bedienelementkappe sind verhindert. Dadurch können auch Fehlbedienungen zumindest reduziert werden und eine nutzerfreundliche und zuverlässige Betätigung der Bedienvorrichtung ist erreicht.

Auch im auf der Bedienelementaufnahme positionierten Zustand des Bedienelements und relativer Bewegung zwischen der Bedienelementkappe und dem Bedienelementsockel ist eine positionssichere Anordnung in der Bedienelementaufnahme erreicht.

Vorzugsweise ist vorgesehen, dass das Haftelement erhaben nach unten über die ebene Unterseite übersteht. Dadurch wird die Auflage- und Haftwirkung des Haftelements verbessert, da zumindest ein Großteil der Gewichtskraft über das Haftelement auf die Bedienelementaufnahme wirkt und somit die Positionssicherung nochmals verbessert ist. Dennoch ist die Unterseite nicht vollflächig mit dem Haftelement auszugestalten, was Vorteile bezüglich der Materialkosten, der Fertigung und dem haptischen Gefühl beim Angreifen durch einen Nutzer hat. Es wird die haftende Wirkung und der Verschiebeschutz erhöht, da das Bedienelement dann auch wesentlich über dieses Haftelement auf der Bedienelementaufnahme aufsitzt und durch die Gewichtskraft somit die Verschiebesicherheit in einer Richtung senkrecht zur Drehachse erhöht ist.

Vorzugsweise ist an der Unterseite eine Nut ausgebildet, in welcher das Haftelement angeordnet ist. Eine mechanisch stabile Befestigung ist dadurch dauerhaft erreicht und ein unerwünscht großer Überstand des Haftelements über die Unterseite ist verhindert, was auch Vorteile bei der Handhabung des Bedienelements beim Aufsetzen auf die Bedienelementaufnahme hat. Eine unerwünschte Verformung oder ein Abreiben des Haftelements ist dadurch ebenfalls verhindert. Durch die Einbringung in eine Nut ist auch eine unerwünschte Verformung oder ein Abreiben des Haftelements verhindert.

Vorzugsweise ist das Haftelement als umlaufender Ring ausgebildet, was die gleichmäßige haftende Halterung in jeder radialen Richtung mit sich bringt. Vorzugsweise ist vorgesehen, dass das Haftelement als umlaufender Ring ausgebildet ist, der rotationssymmetrisch um die Drehachse des Bedienelements angeordnet ist. Dadurch eine umlaufende und somit unterbrechungsfreie Auflage des Haftelements erreicht. Es ist dadurch auch eine umlaufende und somit unterbrechungsfreie Auflage des Haftelements gegeben, so dass in alle Verschieberichtungen auch eine sehr gleichmäßige Haftwirkung erreicht werden kann.

Vorzugsweise ist das Haftelement aus einem Flüssigsilikon ausgebildet, was die oben genannten Vorteile sehr begünstigt und auch bei größeren Temperaturunterschieden, wie sie bei einem Kochfeld auftreten können, die Funktionalität des Haftelements nicht beeinträchtigt.

Vorzugsweise ist zwischen dem Bedienelementsockel und der Bedienelementkappe ein Aufnahmeraum ausgebildet, in dem eine Drehstellungseinstelleinrichtung angeordnet ist. Die Drehstellungseinstelleinrichtung ist zur Drehstellungseinstellung und Drehstellungshalterung ausgebildet und kann daher auch als Drehstellungseinstell- und Drehstellungshalteeinrichtung bezeichnet werden.

Die Drehstellungseinstelleinrichtung umfasst erste Drehstellungseinstellmittel, die an dem Bedienelementsockel in diesem Aufnahmeraum angeordnet sind. Die Drehstellungseinstelleinrichtung umfasst zweite Drehstellungseinstellmittel, die an der Bedienelementkappe angeordnet sind und ebenfalls im Aufnahmeraum angeordnet sind. Die zweiten Drehstellungseinstellmittel sind zur Einstellung einer Drehstellung der Bedienelementkappe relativ zum Bedienelementsockel zur Wechselwirkung mit den ersten Drehstellungseinstellmitteln ausgebildet. Durch eine derartige Ausgestaltung sind besondere Vorteile erreicht. Einerseits ist somit eine Drehstellungseinstelleinrichtung geschaffen, bei denen die entsprechenden Mittel sehr nahe zueinander angeordnet sind, wodurch die Wechselwirkung und die Präzision bei der Einstellung der Drehstellung erhöht ist. Darüber hinaus ist durch eine derartige Integration dieser Drehstellungsmittel in den Aufnahmeraum hinein auch ein kompakter Aufbau erreicht. Nicht zuletzt sind die Drehstellungseinstellmittel dadurch auch geschützt positioniert, so dass eine Verschmutzung verhindert ist. Ferner sind sie durch die Anordnung in dem Aufnahmeraum im Bedienelement und somit im Inneren des Bedienelements auch vor unerwünschten Temperatureinflüssen geschützt.

Insbesondere ist vorgesehen, dass die ersten Drehstellungseinstellmittel Magnete sind, die auf der den zweiten Drehstellungseinstellmitteln zugewandten Seiten eine erste magnetische Polung aufweisen. Vorzugsweise sind die zweiten Drehstellungseinstellmittel Magnete, die auf der den ersten Drehstellungseinstellmitteln zugewandten Seiten ebenfalls eine erste magnetische Polung aufweisen. Diese Ausgestaltung ist besonders vorteilhaft, da eine magnetische Wechselwirkung der Drehstellungseinstellmittel einerseits sehr exakt ist und andererseits derartige Magnete dauerhaft funktionsfähig und robust sind. Gerade auch durch eine derartige Polung der Magnete kann bei der relativen Drehbewegung der Bedienelementkappe zum Bedienelementsockel die oben genannte Präzision der Drehstellungseinstellung nochmals erhöht werden, da durch ein Abstoßungsverhalten in einem bestimmten Bewegungsintervall um eine Drehachse der Bedienelementkappe auch quasi automatisch eine unerwünschte Drehstellung verhindert ist. Denn durch das Abstoßen der Magnete wird dann gegebenenfalls automatisch eine Weiterdrehung der Bedienelementkappe durchgeführt.

Vorzugsweise ist vorgesehen, dass die Drehstellungseinstelleinrichtung zur für einen Nutzer haptisch wahrnehmbaren Einstellung einer Drehstellung ausgebildet ist. Dies ist eine sehr hervorzuhebende Ausführung, da der Nutzer eine Rückmeldung dahingehend erhält, ob er eine für eine Betriebsbedingungseinstellung erforderliche Drehstellung bereits erreicht hat. Darüber hinaus ist durch eine derartige haptisch wahrnehmbare Ausgestaltung auch die zuverlässige Einstellung der Drehstellung erreichbar und dies positionell höchst präzise und genau möglich. Unerwünschte Toleranzen in der Drehstellungseinstellung und damit einhergehende mögliche Fehlinterpretationen der Drehstellung im Hinblick auf die damit dann verbundene gewünschte Betriebsbedingungseinstellung des Haushaltsgeräts können dadurch vermieden werden.

Vorzugsweise ist vorgesehen, dass durch eine berührungslose Wechselwirkung der ersten und zweiten Drehstellungseinstellmittel eine Drehstellung als haptisch wahrnehmbare Einrastung ausgebildet ist. Dies ist dahingehend besonders vorteilhaft, da bei der Möglichkeit einer Endlosdrehung der Bedienelementkappe zum Bedienelementsockel um eine Drehachse der Nutzer quasi relativ orientierungslos im Hinblick auf den bereits zurückgelegten Drehweg wäre. Durch eine derartige Einrastung erfährt der betätigende Nutzer eindeutig die Position der gewünschten Drehstellung, die dann auch sowohl in Umlaufrichtung im Uhrzeigersinn um die Drehachse als auch gegen den Uhrzeigersinn gehalten ist. Das Weiterbewegen der Bedienelementkappe sowohl gegen den Uhrzeigersinn als auch im Uhrzeigersinn fordert dann jeweils eine bewusste Betätigung mit einem dafür vorgesehenen erforderlichen Kraftaufwand durch einen Nutzer um diese eingerastete Drehstellung wieder zu lösen. Diese haptisch wahrnehmbare Einrastung ist somit in dem Zusammenhang keine tatsächliche mechanische Kopplung zwischen zwei Bauteilen, sondern wird durch die berührungslose Wechselwirkung der Drehstellungseinstellmittel durch einen Nutzer nur entsprechend wahrgenommen. Insbesondere ist dies besonders vorteilhaft bei der Ausgestaltung der gegenpoligen Magnete der Drehstellungseinstellmittel.

Vorzugsweise ist vorgesehen, dass die ersten Drehstellungseinstellmittel in Umlaufrichtung um eine Drehachse der Bedienelementkappe angeordnet sind und die zweiten Drehstellungseinstellmittel in Umlaufrichtung um die Drehachse angeordnet sind. Insbesondere ist vorgesehen, dass die ersten und die zweiten Drehstellungseinstellmittel jeweils auf einem Kreis um die Drehachse angeordnet sind, wobei die beiden Kreise vorzugsweise den gleichen Radius aufweisen. Die ersten und zweiten Drehstellungseinstellmittel befinden sich daher auf unterschiedlichen parallelen Ebenen, wobei sich die Ebenen senkrecht zur Drehachse erstrecken.

Insbesondere sind die ersten Drehstellungseinstellmittel in einem ersten Kreis um die Drehachse beabstandet und äquidistant zueinander angeordnet. Entsprechendes ist auch für die zweiten Drehstellungseinstellmittel um einen zweiten Kreis vorgesehen.

Durch diese Anordnung auf jeweils Kreisen und insbesondere auf derartigen Kreisen, die gleichen Radius haben, werden die oben genannten Vorteile im Hinblick auf exakte Wechselwirkung und damit hohe Präzision bei der Drehstellungseinstellung und Halterung begünstigt. Gerade die Drehstellungshalterung ist durch die genannte Ausgestaltung mit Magneten, die gegenpolig sind, besonders präzise und zuverlässig erreicht. Die haptisch wahrnehmbare Einrastung ist dabei vom Nutzer gezielt und genau nachvollziehbar. Vorzugsweise ist vorgesehen, dass bei einer eingestellten Drehstellung in Richtung der Drehachse betrachtet um die Drehachse umlaufend ein zweites Drehstellungseinstellmittel zwischen zwei ersten Drehstellungseinstellmitteln angeordnet ist. Betrachtet man somit das Bedienelement entlang der Drehachse und projiziert die ersten und zweiten Drehstellungseinstellmittel in eine Projektionsebene, so liegen die ersten und zweiten Drehstellungseinstellmittel vorzugsweise auf einem Kreis mit gleichem Radius und es ist ein erstes Drehstellungseinstellmittel zwischen zwei zweiten Drehstellungseinstellmitteln auf diesem Kreis angeordnet. Gerade bei einer Ausführung bei der die Drehstellungseinstellmittel Magneten mit unterschiedlicher Polung sind, ist diese Variante besonders vorteilhaft. Durch die magnetische Wechselwirkung wird erreicht, dass ein zweites Drehstellungseinstellmittel quasi genau mittig zwischen zwei ersten Drehstellungseinstellmittel gehalten wird und somit auch die eingestellte Drehstellung sehr präzise erreicht und gehalten wird.

Insbesondere ist vorgesehen, dass die Anzahl der ersten Drehstellungseinstellmittel größer als die Anzahl der zweiten Drehstellungseinstellmittel ist. Vorzugsweise ist vorgesehen, dass an der Bedienelementkappe zwei zweite Drehstellungseinstellmittel angeordnet sind und an den Bedienelementsockel zumindest acht, insbesondere zumindest zehn, vorzugsweise zwölf erste Drehstellungseinstellmittel angeordnet sind. Diese Drehstellungseinstellmittel sind vorzugsweise jeweils auf einem Kreis um die Drehachse angeordnet. Gerade durch die Anordnung der Drehstellungseinstellmittel im Aufnahmeraum des Bedienelements und sowohl an der Bedienelementkappe als auch an dem Bedienelementsockel ermöglicht neben den bereits oben genannten Vorteilen eine derart entsprechende hohe Anzahl an ersten Drehstellungseinstellmitteln. Durch die unmittelbar benachbarte Anordnung der ersten und zweiten Drehstellungseinstellmittel ist auch bei einer derartig relativ hohen Anzahl an ersten Drehstellungseinstellmitteln eine präzise Detektion der jeweiligen Drehstellung der Bedienelementkappe relativ zum Bedienelementsockel ermöglicht. Es kann durch die hohe Anzahl an ersten Drehstellungseinstellmitteln auch eine hohe Anzahl an unterschiedlichen Drehstellungen ermöglicht und präzise eingestellt und gehalten werden. Dadurch lässt sich die Funktionalität der Bedienvorrichtung erhöhen, da mit einer steigenden Anzahl an unterschiedlichen Drehstellungen auch eine steigende Anzahl an damit verbundenen beziehungsweise verknüpften Betriebsbedingungseinstellungen erreicht ist.

Bei einer weiteren vorteilhaften Ausgestaltung ist vorgesehen, dass die Bedienelementkappe und der Bedienelementsockel zerstörungsfrei lösbar miteinander verbunden sind. Durch eine derartige Ausgestaltung kann eine reversibel wiederholbare Trennung und Wiederzusammenfügung der Bedienelementkappe und des Bedienelementsockels durchgeführt werden. Durch diese Ausgestaltung wird die Reinigung der einzelnen Bauteile des Bedienelements verbessert. Darüber hinaus ist auch die Zugänglichkeit zum Aufnahmeraum erreicht, wodurch Montage- oder Wartungs- oder Austauscharbeiten einfach durchgeführt werden können.

Es kann vorzugsweise vorgesehen sein, dass die Bedienelementkappe und der Bedienelementsockel zerstörungsfrei lösbar mittels magnetischer Haltekraft verbunden sind, insbesondere zum axialen Verbinden und Halten der Bedienelementkappe mit dem Bedienelementsockel ein Haltemagnet an der Bedienelementkappe und ein Haltemagnet an dem Bedienelementsockel jeweils mittig angeordnet sind und magnetisch wechselwirken. Durch eine derartige Ausgestaltung kann eine reversibel wiederholbare Trennung und Wiederzusammenfügung der Bedienelementkappe und des Bedienelementsockels einfach durchgeführt werden. Durch diese Ausgestaltung wird die Reinigung der einzelnen Bauteile des Bedienelements verbessert. Darüber hinaus ist auch die Zugänglichkeit zum Aufnahmeraum erreicht, wodurch Montage- oder Wartungs- oder Austauscharbeiten einfach durchgeführt werden können. Dadurch ist eine sehr schnelle Trennung und positionsgenaue Verbindung der Bedienelementkappe und des Bedienelementsockels möglich.

Insbesondere ist vorgesehen, dass der Haltemagnet in den Bedienelementsockel zur magnetischen Wechselwirkung mit einem bedienelementexternen Zentralmagneten zum magnetischen Halten des gesamten Bedienelements auf der Bedienelementaufnahme ausgebildet ist. Dies ist dahingehend eine besonders vorteilhafte Ausführung, da mit drei Magneten einerseits die haltende Verbindung zwischen den beiden separaten Teilen der Bedienelementkappe und des Bedienelementsockel erreicht ist und andererseits das gesamte Bedienelement dann auch noch an der Bedienelementaufnahme gehalten werden kann. Der Haltemagnet in dem Bedienelementsockel ist somit multifunktional im Hinblick auf seine Haltewirkung ausgebildet und tritt mit zwei weiteren, insbesondere in axialer Richtung angeordneten, Magneten in entsprechende haltende Wechselwirkung. Durch dieses Konzept wird ebenfalls eine sehr bauraumsparende Ausgestaltung ermöglicht.

Insbesondere zum axialen Verbinden und Halten der Bedienelementkappe mit dem Bedienelementsockel sind ein Haltemagnet an der Bedienelementkappe und ein Haltemagnet an dem Bedienelementsockel jeweils mittig angeordnet und magnetisch wechselwirkend. Bei dieser Ausführung sind zwei Magnete mit jeweils einem Nordpol und einem Südpol ausgebildet und spezifisch positioniert.

Insbesondere ist vorgesehen, dass der Haltemagnet in den Bedienelementsockel zur magnetischen Wechselwirkung mit einem bedienelementexternen Zentralmagneten zum magnetischen Halten des gesamten Bedienelements auf der Bedienelementaufnahme ausgebildet ist. Dies ist dahingehend eine besonders vorteilhafte Ausführung, da mit drei Magneten einerseits die haltende Verbindung zwischen den beiden separaten Teilen der Bedienelementkappe und des Bedienelementsockel erreicht ist und andererseits das gesamte Bedienelement dann auch noch an der Bedienelementaufnahme gehalten werden kann. Der Haltemagnet in dem Bedienelementsockel ist somit multifunktional im Hinblick auf seine Haltewirkung ausgebildet und tritt mit zwei weiteren, insbesondere in axialer Richtung angeordneten, Magneten in entsprechende haltende Wechselwirkung. Durch dieses Konzept wird ebenfalls eine sehr bauraumsparende Ausgestaltung ermöglicht.

Es kann auch vorgesehen sein, dass zum axialen Verbinden und Halten ein Haltemagnet an der Bedienelementkappe und ein damit magnetisch wechselwirkendes Bauteil, insbesondere ein ferromagnetisches Element, an dem Bedienelementsockel angeordnet sind. Bei einer derartigen Ausführung kann ein zumindest zweipoliger Magnet eingespart werden und beispielsweise ein Metallelement zur magnetischen Wechselwirkung herangezogen werden. Beispielsweise kann eine metallische Platte dafür vorgesehen sein.

Insbesondere ist bei dieser alternativen Ausführung vorgesehen, dass das magnetisch wechselwirkende Bauteil in dem Bedienelementsockel mit einem Bedienelementexternen Zentralmagneten, der zumindest einen Nordpol und zumindest einen Südpol aufweist, zum magnetischen Halten des gesamten Bedienelements auf der Bedienelementaufnahme magnetisch koppelbar ist.

Es kann bei einer weiteren Ausführung vorgesehen sein, dass ein Haltemagnet an dem Bedienelementsockel und ein damit magnetisch wechselwirkendes Bauteil, insbesondere ein ferromagnetisches Element, an der Bedienelementkappe angeordnet sind. Auch hier ist somit ein zumindest zweipoliger Magnet eingespart. Beispielsweise kann eine metallische Platte als ferromagnetisches Element vorgesehen sein.

Bei dieser weiteren Alternative ist vorzugsweise der Haltemagnet in dem Bedienelementsockel mit einem Bedienelementexternen magnetisch wechselwirkenden Bauteil, insbesondere einem ferromagnetischen Element, zum magnetischen Halten des gesamten Bedienelements auf der Bedienelementaufnahme magnetisch koppelbar.

Eine weitere Ausgestaltung einer zerstörungsfrei lösbaren Verbindung zwischen der Bedienelementkappe und dem Bedienelementsockel kann durch eine mechanische Verrastung vorgesehen sein. Dadurch ist ebenfalls eine haltende Verbindung geschaffen, bei der auch die Drehbarkeit der Bedienelementkappe gegeben ist. So kann beispielsweise in dem Zusammenhang vorgesehen sein, dass an der Bedienelementkappe oder dem Bedienelementsockel insbesondere eine um die Drehachse rotationssymmetrisch umlaufende Rastaufnahme ausgebildet ist, in die dann ein oder mehrere Rastelemente an der anderen Komponente des Bedienelements eingreifen kann beziehungsweise können.

Vorzugsweise ist vorgesehen, dass in dem Zusammenhang die Rastelemente eine gewisse Verformbarkeit beziehungsweise Elastizität aufweisen, so dass sie beim Zusammenfügen mit der Rastaufnahme ineinandergreifen können und somit entsprechend sich halten können.

Vorzugsweise ist vorgesehen, dass die Bedienvorrichtung eine Infrarot-Sende-Empfangseinrichtung zur Auswahl einer Funktionsteileinheit des Haushaltsgeräts aufweist. Die Infrarot-Sende-Empfangseinrichtung umfasst Sende-Empfangseinheiten, die bedienelementextern unter dem Bedienelementsockel angeordnet sind und zur Detektion durch einen für zumindest Infrarotsignale durchlässigen Boden des Bedienelementsockels ausgebildet ist. Eine derartige Ausgestaltung mit einer Infrarotdetektion ermöglicht in einer Richtung senkrecht zu einer Längsachse des Bedienelements einen besonders kompakten Aufbau und eine sehr zuverlässige Detektion einer Auswahl der Funktionsteileinheit.

In dem Zusammenhang ist vorzugsweise vorgesehen, dass unter dem Bedienelement und vorzugsweise auf einem Schaltungsträger, der unterhalb einer Bedienelementaufnahme angeordnet ist, eine den Funktionsteileinheiten entsprechende Anzahl von Sende-Empfangseinheiten angeordnet ist.

Besonders vorteilhaft ist es, dass neben der Infrarotdurchlässigkeit des Bodens des Bedienelementsockels auch ein Deckel der Bedienelementkappe zumindest bereichsweise für Infrarotsignale durchlässig ist. Berührt in dem Zusammenhang dann ein Nutzer an spezifischen Stellen an einer Oberseite des Deckels die Bedienelementkappe, so kann dies durch die Infrarotdetektion erkannt werden und die positionell jeweils zugeordnete Funktionsteileinheit ausgewählt werden.

Durch die dann nachfolgende Einstellung eines Betriebsparameters der Funktionsteileinheit, welches durch das Drehen der Bedienelementkappe erfolgen kann, wird dann genau diese wertmäßige Einstellung des Betriebsparameters ermöglicht. Insbesondere ist dann jede Drehstellung, die eingestellt wird, mit einem bestimmten Wert dieses Betriebsparameters der Funktionsteileinheit verknüpft.

So kann beispielsweise bei einem Haushaltsgerät zum Zubereiten von Lebensmitteln, insbesondere einem Kochfeld, vorgesehen sein, dass durch eine bestimmte positionelle Berührung einer Oberseite des Deckels der Bedienelementkappe eine spezifisch zugeordnete Kochzone ausgewählt wird und dann nachfolgend durch ein Drehen der Bedienelementkappe eine gewünschte Kochstufe dieser ausgewählten Kochzone eingestellt werden kann.

Vorzugsweise ist vorgesehen, dass der Boden des Bedienelementsockels aus einem Kunststoff, vorzugsweise PSU (Polysulfon) oder PESU (Polyethersulfon) ausgebildet ist. Diese Kunststoffe sind ganz besonders vorteilhaft, da sie vorteilhafte mechanische und optische Eigenschaften bezüglich der Stabilität und Verwindungssteifigkeit einerseits und der Wellenlängendurchlässigkeit andererseits aufweisen. Darüber hinaus sind sie auch sehr robust gegenüber auch sehr stark schwankenden Temperatureinflüssen, wie dies beispielsweise bei einem Einsatz bei einem Gargerät, beispielsweise einem Kochfeld, der Fall sein kann. Diese Kunststoffmaterialien sind sehr hitzebeständig und weisen darüber hinaus jedoch auch die erforderliche Transparenz im für den Menschen sichtbaren Spektralbereich und im Infrarotstrahlenbereich auf.

Vorzugsweise ist vorgesehen, dass an einer Unterseite beziehungsweise einer Innenseite des Deckels der Bedienelementkappe Dreherkennungsmarkierungen ausgebildet sind. Abhängigkeit von der jeweils eingestellten Drehstellung und einer extern zum Bedienelement angeordneten Drehstellungserkennungseinrichtung wird dann die Drehstellung erkannt und die dann verknüpfte Betriebsbedingungseinstellung, insbesondere die Einstellung einer Kochstufe einer Kochzone, durchgeführt. Die Drehstellungserkennungseinrichtung bzw. Drehstellungserfassungseinrichtung ist vorzugsweise unter der Bedienelementaufnahme und somit auch unterhalb einer Kochfeldplatte eines Kochfelds angeordnet. Sie ist insbesondere auf einem Schaltungsträger positioniert. Die Drehstellungserkennungseinrichtung umfasst vorzugsweise Detektoren, die auf optischer Basis arbeitend die Drehstellung erfassen. Dazu wird vorzugsweise eine Auswertung der von den Detektoren durch den Bedienelementsockel hindurch tretende Strahlung ausgewertet. Abhängig davon, ob dieses emittierte Licht der Detektoren beim Drehen der Bedienelementkappe von einer oder mehreren Dreherkennungsmarkierungen überstrichen wird, wird dann die jeweils zugehörigen Drehstellung und die damit verbundene Betriebsbedingungseinstellung erkannt.

Vorzugsweise ist vorgesehen, dass der Boden des Bedienelementsockels und der Deckel der Bedienelementkappe in den jeweils benötigen Flächenbereichen für die jeweiligen Wellenlängen der Infrarotsignale und/oder der optischen Signale durchlässig sind, um dann die jeweiligen Funktionalitäten durchführen und die gewünschten Informationen erhalten zu können.

Es kann darüber hinaus auch vorgesehen sein, dass in dem Aufnahmeraum des Bedienelements zumindest ein Lichtleiter angeordnet ist, der vorzugsweise in einer Vertiefung des Bedienelementsockels angeordnet ist. Durch eine derartige Ausgestaltung mit einem Lichtleiter kann einem Nutzer auch optisch Information am Bedienelement präsentiert werden. So kann in dem Zusammenhang auch angezeigt werden, ob die gewünschte Auswahl der Funktionsteileinheit erfolgt ist, so dass dies schnell und intuitiv durch einen Nutzer wahrgenommen werden kann.

In besonders vorteilhafter Weise ist vorgesehen, dass die Infrarot-Sende-Empfangseinrichtung so gestaltet und angeordnet ist, dass die Sende-Empfangseinheiten unter dem Lichtleiter angeordnet sind und in besonders vorteilhafter Ausgestaltung zur axialen Detektion durch den Lichtleiter hindurch ausgebildet sind. Bei einer Betrachtung in Richtung der Längsachse des Bedienelements deckt somit der Lichtleiter die Infrarot-Sende-Empfangseinheiten quasi von oben ab. Eine derartige Ausgestaltung ermöglicht in einer Richtung senkrecht zu einer Längsachse des Bedienelements einen besonders kompakten Aufbau, da der Lichtleiter und die Empfangseinrichtung quasi untereinander positioniert sind. Die Infrarotstrahlung kann somit quasi nach oben durch den Lichtleiter abgestrahlt werden, ohne dass das Licht im Lichtleiter dadurch beeinträchtigt werden würde. Das durch den Lichtleiter eingekoppelte, hindurch geleitete und wieder ausgekoppelte Licht ist insbesondere Licht im für den Menschen sichtbaren Spektralbereich.

Durch die Anordnung des Lichtleiters und der Infrarot-Sende-Empfangseinheiten kann auch das von oben durch den Lichtleiter durchtretende Infrarotsignal bis zur darunter liegenden Infrarot-Sende-Empfangseinrichtung uneingeschränkt gelangen.

Vorzugsweise ist vorgesehen, dass der Lichtleiter als ringscheibenförmiger Körper ausgebildet ist, an dessen Rand ein nach oben erhabener Steg als Lichtauskoppelbereich ausgebildet ist. Diese Ausgestaltung des Lichtleiters ermöglicht vom Lichteinkoppelbereich bis zu dem den Lichtauskoppelbereich bildenden Steg eine sehr flach bauende Ausgestaltung des Lichtleiters, die darüber hinaus durch die Ringstruktur sehr stabil und verwindungssteif ist. Durch den Steg als Lichtauskoppelbereich wird dieser geometrisch und bezüglich der Orientierung exakt definiert und bleibt in dem Zusammenhang auch dauerhaft positionell entsprechend erhalten, so dass die Richtung der Lichtabstrahlung aus dem Lichtauskoppelbereich sehr präzisiert ist. Insbesondere ist der Lichtleiter einstückig ausgestaltet.

Der Lichtleiter umfasst einen Lichteinkoppelbereich, der in radialer Richtung und somit senkrecht zur Längsachse betrachtet, näher zur Längsachse angeordnet ist als der Lichtauskoppelbereich. Insbesondere ist vorgesehen, dass Lichtquellen unter dem Lichteinkoppelbereich des Lichtleiters angeordnet sind und bedienelementextern positioniert sind. Die Lichtquellen sind vorzugsweise auf einem Schaltungsträger, der unter einer Bedienelementaufnahme angeordnet ist, positioniert.

Weitere Merkmale der Erfindung ergeben sich aus den Ansprüchen, den Figuren und der Figurenbeschreibung. Die vorstehend in der Beschreibung genannten Merkmale und Merkmalskombinationen sowie die nachfolgend in der Figurenbeschreibung genannten und/oder in den Figuren alleine gezeigten Merkmale und Merkmalskombinationen sind nicht nur in der jeweils angegebenen Kombination, sondern auch in anderen Kombinationen oder in Alleinstellung verwendbar, ohne den Rahmen der Erfindung zu verlassen. Es sind somit auch Ausführungen von der Erfindung als umfasst und offenbart anzusehen, die in den Figuren nicht explizit gezeigt und erläutert sind, jedoch durch separierte Merkmalskombinationen aus den erläuterten Ausführungen hervorgehen und erzeugbar sind.

Ausführungsbeispiele der Erfindung werden nachfolgend anhand schematischer Zeichnungen näher erläutert. Es zeigen:
- Fig. 1: eine perspektivische Darstellung eines Ausführungsbeispiels eines erfindungsgemäßen Haushaltsgeräts;
- Fig. 2: eine perspektivische Schnittdarstellung des Haushaltsgeräts gemäß Fig. 1;
- Fig. 3: eine Schnittdarstellung der Ausführung in Fig. 2;
- Fig. 4: eine Draufsicht auf Teilkomponenten der Bedienvorrichtung gemäß Fig. 1 und Fig. 2, wie sie in dem Haushaltsgerät verbaut sind;
- Fig. 5: eine Ansicht auf eine Unterseite eines Deckels des Bedienelements der Bedienvorrichtung gemäß Fig. 2 und Fig. 3;
- Fig. 6: eine perspektivische Schnittdarstellung eines weiteren Ausführungsbeispiels eines Bedienelements der Bedienvorrichtung;
- Fig. 7: eine Explosionsdarstellung des Bedienelements gemäß Fig. 6;
- Fig. 8: eine perspektivische Schnittdarstellung eines weiteren Ausführungsbeispiels eines Bedienelements einer Ausführung einer erfindungsgemäßen Bedienvorrichtung;
- Fig. 9: eine Explosionsdarstellung des Bedienelements gemäß Fig. 8; und
- Fig. 10: eine perspektivische Schnittdarstellung eines weiteren Ausführungsbeispiels eines Bedienelements einer Ausführung einer erfindungsgemäßen Bedienvorrichtung.

In den Figuren werden gleiche oder funktionsgleiche Elemente mit den gleichen Bezugszeichen versehen.

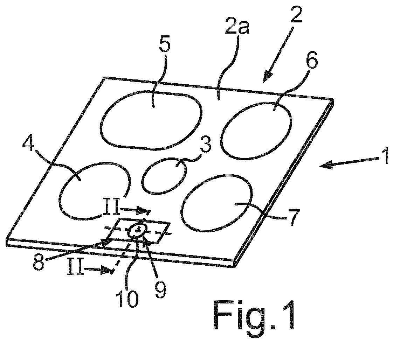

In Fig. 1 ist in einer schematischen Darstellung ein als Kochfeld 1 ausgebildetes Haushaltsgerät zum Zubereiten von Lebensmitteln gezeigt. Das Kochfeld 1 umfasst eine als Haushaltsgeräteplatte ausgebildete Kochfeldplatte 2, die aus Glas oder Glaskeramik ausgebildet sein kann. Auf einer Oberseite 2a der Kochfeldplatte 2 sind in Anzahl, Position und Formgebung lediglich beispielhaft fünf Kochzonen 3, 4, 5, 6 und 7 dargestellt.

Unter der Kochfeldplatte 2 sind in Fig. 1 nicht gezeigte Heizeinheiten angeordnet, um die Flächenbereiche der Kochzonen 3 bis 7 beheizen zu können, wobei auf den Kochzonen 3 bis 7 Zubereitungsgefäße mit Speisen zur Zubereitung aufgestellt werden können. In dem Zusammenhang sind als Heizeinheiten beispielsweise sowohl Strahlungsheizkörper als auch Induktoren zu verstehen, bei denen entsprechende Energie zur Erwärmung der Speisen in Zubereitungsgefäßen eingebracht wird. Bei Induktoren werden, wie bekannt, die Kochzonen 3 bis 7 in Form des Material der Kochfeldplatte 2 nicht direkt aufgeheizt, sondern durch die elektromagnetische Wechselwirkung nur das Zubereitungsgefäß direkt erhitzt.

Das Kochfeld 1 umfasst darüber hinaus eine Bedienvorrichtung 8, welche im Ausführungsbeispiel im vorderen Bereich der Kochfeldplatte 2 angeordnet ist. Die Bedienvorrichtung 8 umfasst eine Bedienelementaufnahme 9, welche im Ausführungsbeispiel in der Kochfeldplatte 2 angeordnet ist. In der Bedienelementaufnahme 9 ist ein Bedienelement 10 positionierbar. Das Bedienelement 10 ist im Ausführungsbeispiel scheibenförmig oder diskusförmig ausgestaltet und zerstörungsfrei lösbar und somit reversibel abnehmbar und wieder aufsetzbar auf die Kochfeldplatte 2, insbesondere die Bedienelementaufnahme 9, ausgebildet. Die Bedienelementaufnahme 9 kann ein zur Kochfeldplatte separater Einleger sein oder kann ein Teilflächenbereich der Kochfeldplatte 2 sein.

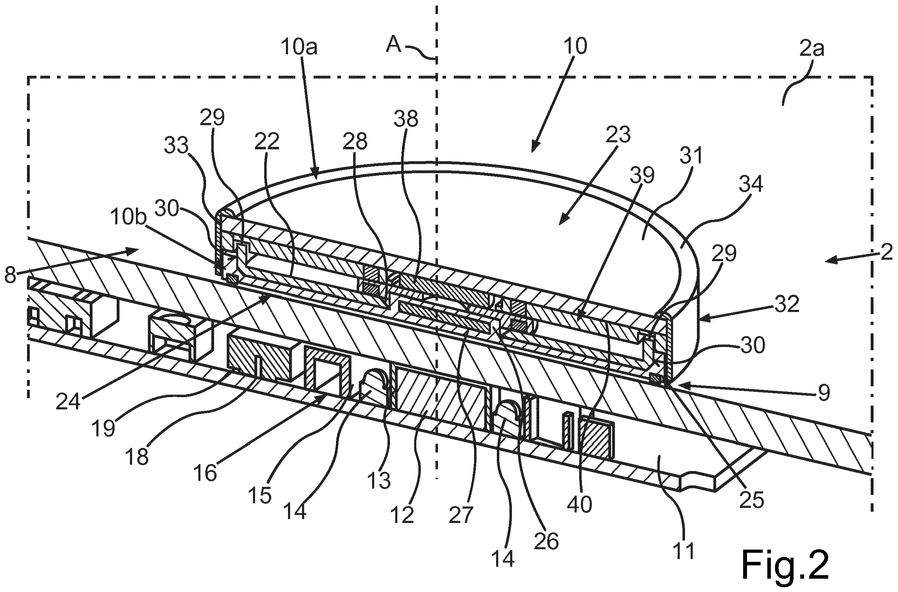

In Fig. 2 ist in einer perspektivischen Schnittdarstellung entlang der Schnittlinie II-II das Kochfeld 1 im Bereich der Bedienvorrichtung 8 gezeigt.

Die Bedienvorrichtung 8 umfasst unter der Kochfeldplatte 2 einen Schaltungsträger 11, auf dem ein bedienelementexterner Zentralmagnet beziehungsweise Haltemagnet 12 angeordnet ist. Der Haltemagnet 12 ist in einer Aufnahme angeordnet, die als Trennwand 13 zumindest bereichsweise umlaufend um eine Achse A, die die Längsachse der Bedienvorrichtung 8 und somit auch des Bedienelements 10 darstellt, angeordnet. In einer Richtung senkrecht zur Achse A und somit in radialer Richtung ist unmittelbar an dem Haltemagnet 12 und die Trennwand 13 anschließend eine Mehrzahl von Lichtquellen 14 positioniert. Die Lichtquellen 14 sind in Umlaufrichtung um die Achse A beabstandet und äquidistant zueinander angeordnet. Die Lichtquellen 14 sind vorzugsweise Leuchtdioden.

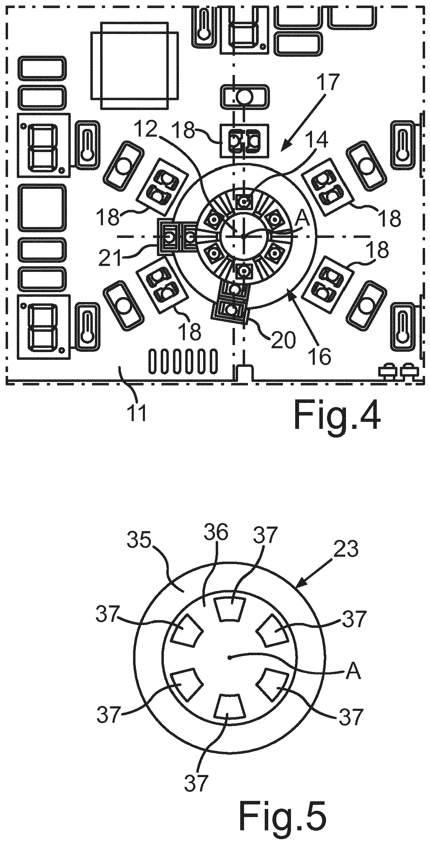

Wiederum radial nach außen anschließend an die Lichtquellen 14 ist eine weitere Wand 15 ausgebildet, die einer Einhausung komponentenspezifisch zugeordnet ist. Zu dieser Einhausung ist auch die innere Aufnahme beziehungsweise die Trennwand 13 zugehörig. Im Ausführungsbeispiel ist die Wand 15 Bestandteil eines umlaufenden Rings 16. Durch die Wand 15 beziehungsweise den Ring 16 wird eine Streulichtabschottung erreicht, so dass das Licht von den Lichtquellen 14 nicht unerwünscht seitlich nach außen strahlt. Die Bedienvorrichtung 8 umfasst darüber hinaus eine Infrarot-Sende-Empfangseinrichtung 17 (Fig. 4), die eine Mehrzahl, im Ausführungsbeispiel fünf, Sende-Empfangseinheiten 18 aufweist. Die Anzahl der Sende-Empfangseinheiten 18 entspricht der Anzahl an Kochzonen 3 bis 7. Die Sende-Empfangseinheiten 18 sind durch jeweils Einhausungen 19 ebenfalls seitlich entsprechend umgeben, so dass die Detektion verbessert ist und auch hier keine Streulichteffekte oder dergleichen einwirken können.

Darüber hinaus umfasst die Bedienvorrichtung 8 noch Detektoren 20 (Fig. 5) und 21, mittels welchen eine Dreherkennung beziehungsweise eine Dreherfassung des Bedienelements 10 um die Drehachse beziehungsweise Längsachse A relativ zur Oberseite 2a und somit auch zur Bedienelementaufnahme 9 erfassbar ist.

Es ist an dieser Stelle zu erwähnen, dass das Bedienelement 10 eine Bedienelementkappe 10a und einen Bedienelementsockel 10b aufweist. Der Bedienelementsockel 10b und die Bedienelementkappe 10a sind relativ zueinander bewegbar und in dem Zusammenhang um die Achse A relativ zueinander drehbar.

Das gesamte Bedienelement 10 und somit die Bedienelementkappe 10a und der Bedienelementsockel 10b sind durch magnetische Haltekräfte an der Bedienelementaufnahme 9 zerstörungsfrei lösbar anbringbar.

Dazu ist vorgesehen, dass ein bedienelementinterner weiterer Haltemagnet 27 in dem Bedienelementsockel 10b angeordnet ist. Dieser Haltemagnet 27 tritt in magnetische Wechselwirkung mit dem Zentralmagnet beziehungsweise bedienelementexternen Haltemagnet 12, um das gesamte Bedienelement 10 auf der Bedienelementaufnahme 9 zu halten.

Zur Verbindung der Bedienelementkappe 10a und des Bedienelementsockels 10b ist ein dritter Haltemagnet 38 vorgesehen, der in der Bedienelementkappe 10a befestigt ist.

Durch die magnetische Wechselwirkung der Haltemagneten 27 und 38, die zentral mittig im Bedienelement 10 angeordnet sind, wird zumindest ein sicheres ein axiales Halten der Bedienelementkappe 10a zum Bedienelementsockel 10b erreicht.

Wie aus der Darstellung in Fig. 2 zu erkennen ist, sind die drei Magnete 12, 27 und 38 allesamt in vertikaler Richtung übereinander angeordnet und insbesondere auch koaxial zur Achse A positioniert. Durch eine derartige Ausgestaltung und Anordnung der Haltemagnete 27 und 38 ist einerseits das axiale Halten, andererseits die relative Bewegbarkeit und insbesondere das relative Drehen der Bedienelementkappe 10a zum Bedienelementsockel 10b erreicht. Der Bedienelementsockel 10b ist in aufgesetztem Zustand des Bedienelements 10 auf die Bedienelementaufnahme 9 ortsfest positioniert.

Wie aus der Darstellung in Fig. 2 des Weiteren zu erkennen ist, sind in vertikaler Richtung und somit in Richtung der Achse A betrachtet, die Sende-Empfangseinheiten 18 innerhalb der Ausmaße des Bedienelements 10 angeordnet und insbesondere unter einem Lichtleiter 22 positioniert.

Der Lichtleiter 22 ist bedienelementintern angeordnet und somit in einem Aufnahmeraum 39 angeordnet, wobei der Aufnahmeraum 39 durch die Bedienelementkappe 10a und dem Bedienelementsockel 10b begrenzt beziehungsweise umhüllt ist.

Die Bedienelementkappe 10a umfasst einen Deckel 23, wobei der Bedienelementsockel 10b einen Boden 24 aufweist. Eine Mantelwand 25 ist einstückig mit dem Boden 24 verbunden und somit dem Bedienelementsockel 10b zugehörig.

Auf einer dem Aufnahmeraum 39 zugewandten Innenseite des Bodens 25 ist darüber hinaus eine Aufnahme 26 für den Haltemagneten 27 ausgebildet.

Der Schaltungsträger 11 mit seinen darauf angeordneten Elementen, wie sie in Fig. 2 zu erkennen sind, ist unterhalb der Kochfeldplatte 2 angeordnet, wohingegen das Bedienelement 10 auf der Bedienelementaufnahme 9 über die Oberseite 2a anbringbar ist.

Der Lichtleiter 22 umfasst einen Lichteinkoppelbereich 28, der näherliegend zur Achse A angeordnet ist, als ein Lichtauskoppelbereich 29. Der Lichtleiter 22 ist als ringförmige Scheibe gestaltet, wobei an seinem der Achse A abgewandten radialen äußeren Ende ein nach oben sich erstreckender erhabener Steg 30 ausgebildet ist, der dann an seinem Ende den Lichtauskoppelbereich 29 bildet. Die Lichtquellen 14 sind in Richtung der Achse A betrachtet in gradliniger Verlängerung unter dem Lichteinkoppelbereich 28 ausgebildet.

Der Boden 24 ist vollflächig ausgebildet und deckt somit den Lichtleiter 22 von unten her vollständig ab. Das Licht der Lichtquellen 14 wird somit zunächst erst durch den Boden 24 und dann zum Lichteinkoppelbereich 28 abgestrahlt. Der Boden 24 ist vorzugsweise aus einem für Licht im für den Menschen sichtbaren Spektralbereich als auch für Infrarotstrahlen durchlässig. Insbesondere ist der Boden aus einem Kunststoff, vorzugsweise aus PSU oder PESU ausgebildet. Mittels der Infrarot-Sende-Empfangseinrichtung 17 und somit auch mit den Sende-Empfangseinheiten 18, die auf Basis der Detektion von Infrarotstrahlen arbeiten, ist eine Ausgestaltung ausgebildet, die zur Erfassung einer Auswahl einer Funktionsteileinheit des Kochfelds ausgebildet ist. Insbesondere ist diese Einrichtung 17 dazu ausgebildet, die Auswahl einer Kochzone 3 bis 7 zu erfassen. Dazu ist jede der Infrarot-Sende-Empfangseinheiten 18 mit einer der Kochzonen 3 bis 7 bezüglich der gewünschten Auswahl verknüpft, was durch eine nicht gezeigte Steuereinheit dann erkannt und ausgewertet wird und die dann der jeweiligen Kochzone 3 bis 7 zugeordnete Heizeinheit aktiviert wird. In dem Zusammenhang ist es vorgesehen, dass ein Nutzer beispielsweise mit einem Finger auf eine Oberseite 31 des Deckels 23 örtlich spezifisch aufgreift beziehungsweise den Finger entsprechend auflegt, so dass dieses über die Infrarot-Sende-Empfangseinheiten 18 örtlich erkannt wird. Ist beispielsweise vorgesehen, dass die Kochzone 4 ausgewählt werden soll, so legt der Nutzer einen Finger auf die Oberseite 31 an der örtliche spezifizierten vorgesehenen Fläche an der Oberseite 31 auf, die sich vertikal über der zugeordneten Infrarot-Sende-Empfangseinheit 18 befindet. Beispielsweise kann dies in dem Zusammenhang gemäß der Draufsichtdarstellung auf den Schaltungsträger 11 in Fig. 4 die linke untere Infrarot-Sende-Empfangseinheit 18 sein. Die in Umlaufrichtung um die Achse A, die gemäß Fig. 4 senkrecht zur Figurenebene verläuft, nachfolgende Infrarot-Sende-Empfangseinheit 18 ist dann der Kochzone 5 zugeordnet, wobei die dann in Umlaufrichtung im Uhrzeigersinn um die Achse A wiederum nachfolgende Infrarot-Sende-Empfangseinheit 18 der Kochzone 3 zugeordnet ist, die dann nachfolgende Infra-Sende-Empfangseinheit der Kochzone 6 zugeordnet ist und die schließlich in Umlaufrichtung im Uhrzeigersinn um die Achse A in Fig. 4 rechts und vorn und unten angeordnet die Infrarot-Sende-Empfangseinheit 18 der Kochzone 7 zugeordnet ist.

Der Deckel 23 ist im Ausführungsbeispiel aus einem chemisch gehärteten Glas ausgebildet und örtlich lokal lichtundurchlässig sowie an anderen örtlich lokalen Flächenbereichen für Licht im für den Menschen sichtbaren Spektralbereich und für Infrarotstrahlen durchlässig.

Darüber hinaus umfasst das Bedienelement 10 ein ringförmiges Abschlusselement 32, welches der Bedienelementkappe 10a zugehörig ist. Dieses Abschlusselement 32 übergreift außenseitig die Mantelwand 25, so dass in axialer Richtung ein Überlappen zwischen der Mantelwand 25 und dem Abschlusselement 32 gegeben ist.

Das Abschlusselement 32 umgreift auch einen Seitenrand 33 des Deckels 23. Darüber hinaus umfasst dieses Abschlusselement 32 einen oberen Flansch beziehungsweise einen Auflagesteg 34, der auf der Oberseite 31 aufliegt. Vorzugsweise ist dieses Abschlusselement 32 aus Edelstahl oder Kunststoff ausgebildet.

Der Lichtleiter 22 ist mit seinem Auskoppelbereich 29 vollständig von dem Deckel 23 abgedeckt, wobei die Teilfläche des Deckels 23, welche in vertikaler Richtung über dem Lichtauskoppelbereich 29 angeordnet ist, für Licht im sichtbaren Spektralbereich und auch für Infrarotstrahlen durchlässig ist.

Zur Ausgestaltung der jeweiligen Teilflächen einer Unterseite 40 des Deckels 23 ist gemäß der Darstellung in Fig. 5, die eine Ansicht auf diese Unterseite 40 des Deckels 23 zeigt, eine ringförmige Bedruckung oder eine Folie 35 vorgesehen, die für Licht im sichtbaren Spektralbereich und für Infrarotstrahlen durchlässig ist. Radial nach innen anschließend an diesen die Fläche der Unterseite 40 als äußerer umlaufender Ring bildenden Folie 35 ist ein bedruckter oder mit einer Folie versehener Bereich 36 ausgebildet, der für Infrarotstrahlen und Licht im sichtbaren Spektralbereich undurchlässig ist. In diesem Flächenbereich sind mehrere in Umlaufrichtung um die Achse A benachbart und beabstandet zueinander angeordnete Markierungen 37 ausgebildet, die insbesondere farblich weiß gestaltet sind. Durch diese Markierungen 27 wird mittels den Detektoren 20 und 21 die Drehrichtung und der Drehweg der Bedienelementkappe 10a um die Achse A ermittelt und daraus die gewünschte Einstellung eines Betriebsparameters der ausgewählten Funktionsteileinheiten von der Kochzone 3 bis 7 eingestellt. Insbesondere wird durch diese Drehrichtung und die Drehweite die Kochstufe der ausgewählten Kochzone 3 bis 7 eingestellt.

Die Markierungen 37 sind radial so positioniert, dass sie bei einem Drehen des Bedienelements 9 um die Achse A bis über den Detektoren 20 und 21 hinweg laufen und dadurch eher als die Drehrichtung und die gewünschte Wertmäßigkeit der Kochstufe erkannt und eingestellt wird. Dies ist insbesondere abhängig davon, wie viele derartige Markierungen 37 über zumindest einen Detektor 20, 21 hinweg beziehungsweise vorbeilaufen.

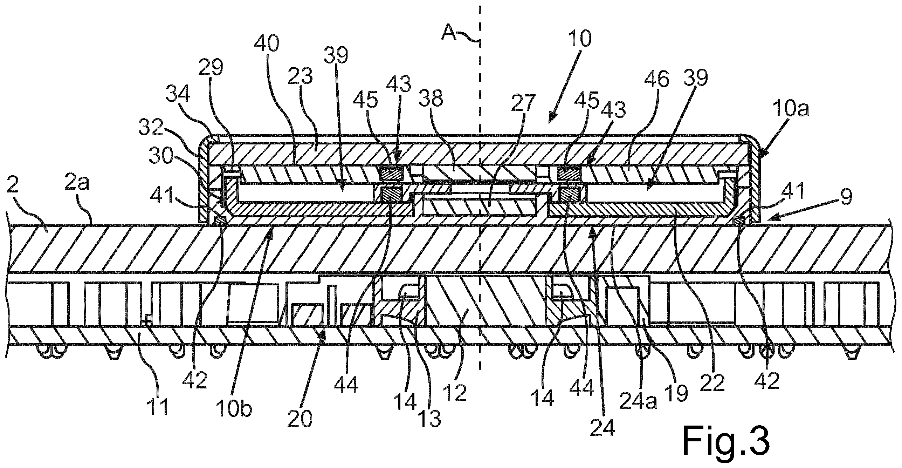

In Fig. 3 ist eine Schnittdarstellung der Fig. 2 gezeigt, wobei hier die Kochfeldplatte 2 mit aufgesetztem Bedienelement 10 dargestellt ist.

Wie dort zu erkennen ist, weist der Boden 24 eine Unterseite 24a auf. In dieser Unterseite 24a, die auf der Oberseite 2a der Kochfeldplatte 2 bereichsweise aufliegen kann, wenn das Bedienelement 10 in der Bedienelementaufnahme 9 aufliegend angeordnet ist, ist eine umlaufende Nut 41 ausgebildet, die somit eine Ringnut darstellt. In dieser Nut 41 ist ein Haftelement 42 angeordnet, welches aus der Nut 41 teilweise nach unten gegenüber der Unterseite 24a überstehend angeordnet ist. Dieses Haftelement 42 weist einen größeren Reibungswiderstand auf, als die Unterseite 24a. Insbesondere ist dieses Haftelement 42 aus Flüssigsilikon ausgebildet. Durch eine derartige Ausgestaltung wird eine verbesserte Haftung und Verrutschsicherheit des aufgesetzten Bedienelements 10 erreicht, was gerade bei dieser mehrteiligen Ausgestaltung des Bedienelements 10 mit einer drehbaren Bedienelementkappe 10a vorteilhaft ist.

Das Bedienelement 10 wird somit im auf die Bedienelementaufnahme 9 aufgebrachten Zustand durch die magnetische Wechselwirkung zwischen den Haltemagneten 12 und 27 und das Haftelement 42 axial und radial gehalten. Dabei trägt die magnetische Wechselwirkung zwischen den Haltemagneten 12 und 27 verstärkt zur axialen Positionsführung bei, wohingegen das Haftelement 42 im Wesentlichen zur horizontalen und somit radialen Verrutschsicherheit beiträgt.

In dem Aufnahmeraum 39 des Bedienelements 10 ist darüber hinaus eine Drehstellungseinstelleinrichtung 43 ausgebildet. Diese Drehstellungseinstelleinrichtung 43 ist somit vollständig bedienelementintern ausgestaltet und umfasst erste Drehstellungseinstellmittel, die als Magnete 44 in dem Bedienelementsockel 10b angeordnet sind. Im Ausführungsbeispiel ist vorgesehen, dass in dem Bedienelementsockel 10b zumindest acht, vorzugsweise zumindest zehn, insbesondere zwölf derartige Magnete 44 angeordnet sind. Diese Magnete 44 weisen eine erste magnetische Polung auf. Sie sind in einem Kreis um die Achse A beabstandet und äquidistant zueinander angeordnet.

Die Drehstellungseinstelleinrichtung 43 umfasst darüber hinaus zweite Drehstellungseinstellmittel, die als Magnete 45 ausgebildet sind und in der Bedienelementkappe 10a angeordnet sind. Die Magnete 44 weisen auf der den Magneten 45 zugewandten Seiten die gleiche magnetische Polung auf, wie die Magnete 45 auf der den Magneten 44 zugewandten Seiten. Die Anzahl dieser Magnete 45 ist kleiner als die Anzahl der Magnete 44. Im Ausführungsbeispiel ist vorgesehen, dass die Anzahl der Magnete 45 zwei oder vier beträgt.

Diese Magnete 45 sind ebenfalls auf einem Kreis um die Achse A angeordnet, wobei der Radius dieses Kreises der Magnete 45 gleich oder im Wesentlichen gleich dem Radius des Kreises der Magnete 44 ist.

Die Magnete 44 sind zur Drehstellungseinstellung in magnetischer Wechselwirkung mit den Magneten 45. Es ist dabei vorgesehen, dass die Drehstellungseinstelleinrichtung 43 zur für einen Nutzer haptisch wahrnehmbaren Einstellung einer Drehstellung ausgebildet ist. Insbesondere ist dabei vorgesehen, dass durch die berührungslose Wechselwirkung der Magnete 44 und 45 eine Drehstellung als haptisch wahrnehmbare Einrastung ausgebildet ist. In dem gezeigten Ausführungsbeispiel ist eine Drehstellung dann erreicht, wenn ein Magnet 45 bei einer Projektionsbetrachtung entlang der Achse A zwischen zwei Magneten 44 angeordnet ist. Durch die entgegengesetzte Polarität der Magnete 44 und 45 wird praktisch verhindert, dass ein Magnet 45 in vertikaler Richtung betrachtet direkt über einem Magneten 44 angeordnet ist und dann die Bedienelementkappe 10a in einer derartigen Stellung selbständig verbleiben würde. Vielmehr ist durch die Ausgestaltung der Magnete 44 und 45 eine sich quasi selbst haltende Drehstellung der Bedienelementkappe 10a relativ zum Bedienelementsockel 10b dann erreicht, wenn der Magnet 45 eben genau zwischen zwei benachbarten Magneten 44 bei einer entsprechenden Projektionsbetrachtung entlang der Achse A positioniert ist. Diese dann auch wahrnehmbare haptische Einrastung in diese Drehstellung wird durch die berührungslose magnetische Wechselwirkung bezüglich der Abstoßung der Magnete 44 und 45 ermöglicht. Der Nutzer kann somit intuitiv und leicht nachvollziehbar die jeweilige Drehstellung bemerken und die damit verbundene Einstellung des Betriebsparameterwerts für die ausgewählte Funktionsteileinheit in Form einer Kochzone 3 bis 7 auch verspüren. Vorzugsweise ist jeder möglichen Drehstellung ein individueller Betriebsparameterwert zugeordnet, so dass entsprechend Einstellungen möglich sind. Aufgrund der Funktionalität und Ausgestaltung der Drehstellungseinstelleinrichtung 43 sind diesbezüglich die Drehstellungseinstellung und auch dann die Haltung der eingestellten Drehstellung erreicht.

Wie zu erkennen ist, sind die Magnete 44 auf einem Kreis angeordnet, die in radialer Richtung mit einem größerem Radius wie die Trennwand 13 ausgebildet ist, jedoch unmittelbar benachbart dazu verläuft. Dadurch ist der weitere radiale Bereich zwischen dem Steg und den Magneten 44 nicht belegt, so dass dadurch die Aussendung und der Empfang der optischen Signale und der Infrarotsignale ungehindert erfolgen kann. Entsprechend sind auch die Magnete 45 auf dem dazu vorgesehenen Kreis relativ nahe zum Haltemagneten 38 angeordnet.

Wie aus der Darstellung in Fig. 3 auch zu erkennen ist, umfasst die Bedienelementkappe 10a ein Trägerteil 46, welches an der Unterseite 40 des Deckels 23 angeordnet ist und sowohl die Magnete 45 als auch den Haltemagneten 38 trägt.

Es ist zu erwähnen, dass in Fig. 3 eine Schnittdarstellung gezeigt ist, bei der die Bedienelementkappe 10a bewusst in einer Stellung relativ zum Bedienelementsockel 10b gehalten ist, bei dem die Magnete 44 und 45 übereinander liegen, um diesbezüglich die jeweiligen radialen Positionen der Magnete 44 und 45 zu verdeutlichen. Es wurde bereits oben erläutert, dass eine derartige Position aufgrund der Abstoßung der Magnete 44 und 45 nicht gegeben ist und keine sich selbst haltende Drehstellung und haptisch wahrnehmbare Einrastung darstellt.

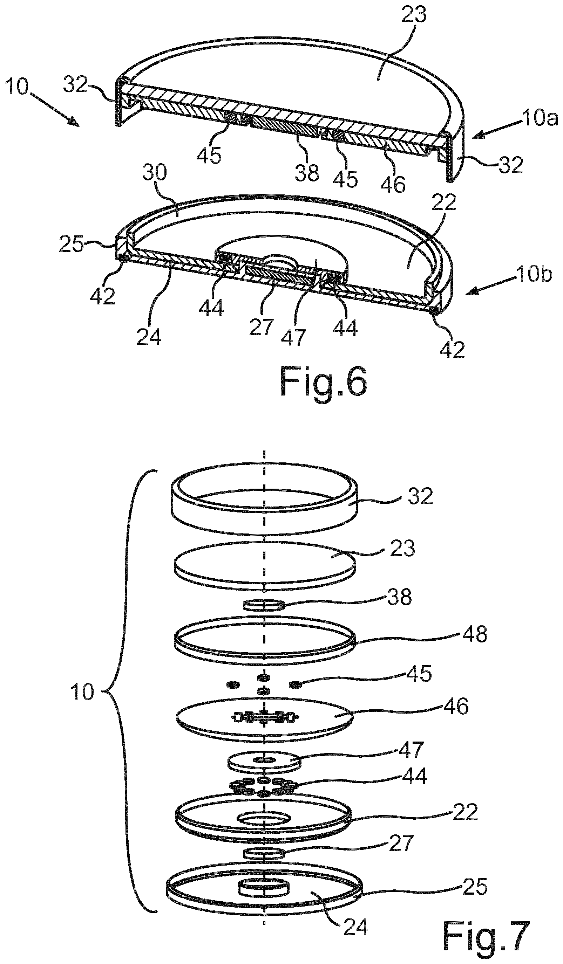

In Fig. 6 ist in einer weiteren perspektivischen Schnittdarstellung eine Explosionsansicht des Bedienelements 10 gemäß den Darstellungen in Fig. 2 und Fig. 3 gezeigt. Eine die Magnete 44 aufnehmende ringförmige Trägerplatte 47 des Bedienelementsockels 10b ist zu erkennen.

In Fig. 7 ist eine vollständige Explosionsdarstellung des Bedienelements 10 gemäß Fig. 2, 3 und 6 dargestellt. Dort ist auch ein Ring 48 zu erkennen, der die Trägerplatte 46 umfangsseitig umgreift.

Es kann auch vorgesehen sein, dass der Magnet 27 durch ein ferromagnetische Element, beispielsweise eine metallische Platt ersetzt ist, und die Magnete 38 und 12 ausgebildet sind.

Ebenso kann vorgesehen sein, dass der Magnet 27 ausgebildet ist und die Magnete 38 und 12 durch ferromagnetische Elemente, insbesondere metallische Platten ersetzt sind.

Bevorzugt ist bei den Ausführungen vorgesehen, dass die magnetische Haltekraft zwischen den magnetisch wechselwirkenden Elementen in der Bedienelementkappe 10a und dem Bedienelementsockel 10b größer ist, als die magnetische Haltekraft zwischen den magnetisch wechselwirkenden Elementen in dem Bedienelementsockel 10b und dem Bedienelementexternen Element.

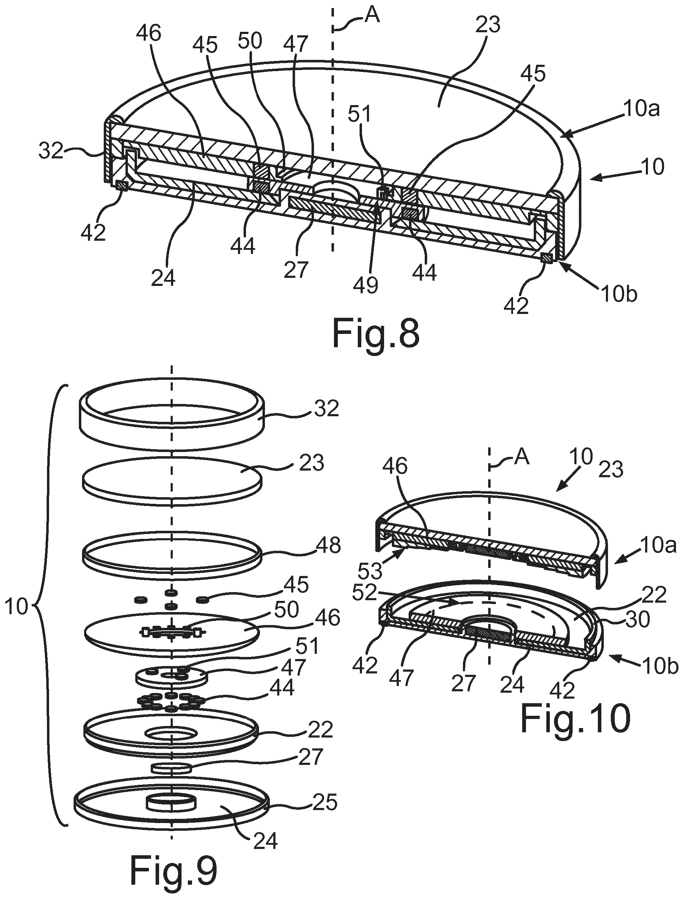

In Fig. 8 ist in einer perspektivischen Schnittdarstellung ein weiteres Ausführungsbeispiel eines Bedienelements 10 gezeigt. Im Unterschied zur Ausgestaltung des bisher erläuterten Ausführungsbeispiels ist hier vorgesehen, dass die zerstörungsfrei lösbare Verbindung zwischen der Bedienelementkappe 10a und dem Bedienelementsockel 10b nicht durch magnetische Wechselwirkung, sondern durch eine mechanische Verrastung 49 ausgebildet. In dem Zusammenhang umfasst die Trägerplatte 46 auf ihrer der Drehachse A zugewandten Innenseite einen Raststeg 50, der durch ein oder mehrere Rastelemente 51, die auf einer dem Deckel 23 zugewandten Oberseite der Trägerplatte 47 ausgebildet sind, hintergriffen beziehungsweise hinterschnappt werden kann, so dass die Verrastung ausgebildet ist.

In Fig. 9 ist eine Explosionsdarstellung des Bedienelements 10 gemäß Fig. 8 gezeigt.

In Fig. 10 ist in einer weiteren perspektivischen Schnittdarstellung ein Ausführungsbeispiel eines weiteren Bedienelements 10 gezeigt. Hier kann ebenfalls eine mechanische Verrastung zwischen der Bedienelementkappe 10a und dem Bedienelementsockel 10b vorgesehen sein, wobei hier an einer Oberseite der Trägerplatte 47 ein Bereich mit einer mechanischen Struktur ausgebildet ist, in dem beispielsweise entsprechende Vertiefungen 52 vorgesehen sind, in welche komplementär einsteckbare beziehungsweise verrastbare beziehungsweise verklipsbare Gegenelemente 53 eingreifen können. Die Gegenelemente 53 sind vorzugsweise an einer Unterseite der Trägerplatte 46 angeordnet Ebenso kann, wie durch die Darstellung in Fig. 10 symbolisiert, alternativ eine magnetische Verrastung vorgesehen sein. Dazu kann die Verrastung in Umlaufrichtung um die Achse A eine wellenartige Oberflächenstruktur bei der Trägerplatte 47 aufweisen, an welcher eine komplementär gewellte Unterseite der Trägerplatte 46 entlang gleitet, wenn die Bedienelementkappe 10a um den Bedienelementsockel 10b gedreht wird. Wenn ein Wellenberg in ein Wellental gelangt, dann ist eine Rastposition erreicht.

Alternativ zu einer derartigen Umlaufrastung kann auch eine radiale Rastung vorgesehen sein, bei welcher dann ein Profil gebildet ist, wie es in Fig. 10 gezeigt ist, bei welcher dann die Unterseite der Trägerplatte 46 in radialer Richtung unterschiedlich dick ist. Auch hier kann dann entsprechend komplementär die Oberseite der Trägerplatte 47 in der Dicke variieren.

### Bezugszeichenliste

- 1: Kochfeld
- 2: Kochfeldplatte
- 2a: Oberseite
- 3: Kochzone
- 4: Kochzone
- 5: Kochzone
- 6: Kochzone
- 7: Kochzone
- 8: Bedienvorrichtung
- 9: Bedienelementaufnahme
- 10: Bedienelement
- 10a: Bedienelementkappe
- 10b: Bedienelementsockel
- 11: Schaltungsträger
- 12: Haltemagnet
- 13: Trennwand
- 14: Lichtquellen
- 15: Wand
- 16: Ring
- 17: Infrarot-Sende-Empfangseinrichtung
- 18: Sende-Empfangseinheiten
- 19: Einhausung
- 20: Detektor
- 21: Detektor
- 22: Lichtleiter
- 23: Deckel
- 24: Boden
- 24a: Unterseite
- 25: Mantelwand
- 26: Aufnahme
- 27: Haltemagnet
- 28: Lichteinkoppelbereich
- 29: Lichtauskoppelbereich
- 30: Steg
- 31: Oberseite
- 32: Abschlusselement
- 33: Seitenrand
- 34: Auflagesteg
- 35: Folie
- 36: Bereich
- 37: Markierungen
- 38: Haltemagnet
- 39: Aufnahmeraum
- 40: Unterseite
- 41: Nut
- 42: Haftelement
- 43: Drehstellungseinstelleinrichtung
- 44: Magnete
- 45: Magnete
- 46: Trägerteil
- 47: Trägerplatte
- 48: Ring
- 49: Verrastung
- 50: Raststeg
- 51: Rastelemente
- 52: Vertiefungen
- 53: Gegenelemente
- A: Achse

## Patentansprüche

1. Bedienvorrichtung (8) für ein Haushaltsgerät (1), umfassend ein Bedienelement (10) und eine Bedienelementaufnahme (9), wobei das Bedienelement (10) auf der Bedienelementaufnahme (9) des mit der Bedienvorrichtung (8) steuerbaren Haushaltsgeräts (1) mittels Magnetkraft haltbar und relativ zur Bedienelementaufnahme (9) bewegbar und von dort abnehmbar positionierbar ist, und das Bedienelement (10) einen Bedienelementsockel (10b) und eine den Bedienelementsockel (10b) von oben zumindest bereichsweise abdeckende Bedienelementkappe (10a) aufweist, welche mit dem Bedienelementsockel (10b) verbunden ist und zur Einstellung von Betriebsbedingungen des Haushaltsgeräts (1) relativ zum Bedienelementsockel (10b) drehbar ist, **dadurch gekennzeichnet, dass** die Bedienvorrichtung (8) zumindest ein Haftelement (42) aufweist, welches an einer Unterseite (24a) des Bedienelementsockels (10b) ausgebildet ist, dessen Material einen größeren Reibungswiderstand aufweist, als die Unterseite (24a) des Bedienelementsockels (10b).

2. Bedienvorrichtung (8) nach Anspruch 1, **dadurch gekennzeichnet, dass** das Haftelement (42) erhaben nach unten über die ebene Unterseite (24a) übersteht.

3. Bedienvorrichtung (8) nach Anspruch 2, **dadurch gekennzeichnet, dass** an der Unterseite (24a) eine Nut (41) ausgebildet ist, in welcher das Haftelement (42) angeordnet ist.

4. Bedienvorrichtung (8) nach einem der vorhergehenden Ansprüche, **dadurch gekennzeichnet, dass** Haftelement (42) als umlaufender Ring ausgebildet ist.

5. Bedienvorrichtung (8) nach einem der vorhergehenden Ansprüche, **dadurch gekennzeichnet, dass** das Haftelement (42) aus einem Flüssigsilikon ausgebildet ist.

6. Bedienvorrichtung (8) nach einem der vorhergehenden Ansprüche, **dadurch gekennzeichnet, dass** zwischen dem Bedienelementsockel (10b) und der Bedienelementkappe (10a) ein Aufnahmeraum (39) ausgebildet ist, in dem eine Drehstellungseinstelleinrichtung (43) angeordnet ist, die erste Drehstellungseinstellmittel (44) aufweist, die an dem Bedienelementsockel (10b) angeordnet sind, und zweite Drehstellungseinstellmittel (45) aufweist, die an der Bedienelementkappe (10a) angeordnet sind und zur Einstellung einer Drehstellung der Bedienelementkappe (10a) relativ zum Bedienelementsockel (10b) zur Wechselwirkung mit den ersten Drehstellungseinstellmitteln (44) ausgebildet sind.

7. Bedienvorrichtung (8) nach Anspruch 6, **dadurch gekennzeichnet, dass** die ersten Drehstellungseinstellmittel Magnete (44) sind, die auf der den als Magnete (45) ausgebildeten zweiten Drehstellungseinstellmitteln zugewandten Seiten die gleiche magnetische Polung aufweisen, wie die die zweiten Drehstellungseinstellmittel darstellenden Magnete (45) auf den den Magneten (44) zugewandten Seiten aufweisen.

8. Bedienvorrichtung (8) nach Anspruch 6 oder 7, **dadurch gekennzeichnet, dass** die Drehstellungseinstelleinrichtung (43) zur für einen Nutzer haptisch wahrnehmbaren Einstellung einer Drehstellung ausgebildet ist, insbesondere durch eine berührungslose Wechselwirkung der ersten und zweiten Drehstellungseinstellmittel (44, 45) eine Drehstellung als haptisch wahrnehmbare Einrastung ausgebildet ist.

9. Bedienvorrichtung (8) nach einem der Ansprüche 6 bis 8, **dadurch gekennzeichnet, dass** die ersten Drehstellungseinstellmittel (44) in Umlaufrichtung um eine Drehachse (A) der Bedienelementkappe (10a) angeordnet sind und die zweiten Drehstellungseinstellmittel (45) in Umlaufrichtung um die Drehachse (A) angeordnet sind, insbesondere beide Drehstellungseinstellmittel (44, 45) jeweils auf einem Kreis mit gleichem Radius angeordnet sind.

10. Bedienvorrichtung (8) nach Anspruch 9, **dadurch gekennzeichnet, dass** bei einer eingestellten Drehstellung in Richtung der Drehachse (A) betrachtet um die Drehachse (A) umlaufend ein zweites Drehstellungseinstellmittel (45) zwischen zwei ersten Drehstellungseinstellmitteln (44) angeordnet ist.

11. Bedienvorrichtung (8) nach einem der Ansprüche 6 bis 10, **dadurch gekennzeichnet, dass** die Anzahl der ersten Drehstellungseinstellmittel (44) größer der Anzahl der zweiten Drehstellungseinstellmittel (45) ist, insbesondere an der Bedienelementkappe (10a) zwei oder vier zweite Drehstellungseinstellmittel (45) und an dem Bedienelementsockel (10b) zumindest 8, insbesondere zumindest 10 erste Drehstellungseinstellmittel (44) angeordnet sind.

12. Bedienvorrichtung (8) nach einem der vorhergehenden Ansprüche, **dadurch gekennzeichnet, dass** die Bedienelementkappe (10a) und der Bedienelementsockel (10b) zerstörungsfrei lösbar verbunden sind.

13. Bedienvorrichtung (8) nach Anspruch 12, **dadurch gekennzeichnet, dass** zum zumindest axialen Verbinden und Halten der Bedienelementkappe (10a) und des Bedienelementsockels (10b) jeweils ein Haltemagnet (27, 38) mittig angeordnet ist, insbesondere der Haltemagnet (27) in dem Bedienelementsockel (10b) zur magnetischen Wechselwirkung mit einem Bedienelementexternen Zentralmagneten (12) zum magnetischen Halten des gesamten Bedienelements (10) auf der Bedienelementaufnahme (9) ausgebildet ist.

14. Bedienvorrichtung (8) nach einem der vorhergehenden Ansprüche, **dadurch gekennzeichnet, dass** sie eine Infrarot-Sende-Empfangseinrichtung (17) zur Auswahl einer Funktionsteileinheit (3 bis 7) des Haushaltsgeräts (1) aufweist, die mit Sende-Empfangseinheiten (18) Bedienelementextern unter dem Bedienelementsockel (10b) angeordnet ist und zur Detektion durch einen für zumindest Infrarotsignale durchlässigen Boden (24) des Bedienelementsockels (10b) ausgebildet ist.

15. Haushaltsgerät (1) zum Zubereiten von Lebensmitteln, insbesondere Kochfeld (1), mit einer Bedienvorrichtung (8) nach einem der vorhergehenden Ansprüche.

## Claims

1. Operating device (8) for a household device (1), comprising an operating element (10) and an operating element receptacle (9), wherein the operating element (10) can be held by means of magnetic force on the operating element receptacle (9) of the household device (1) which can be controlled with the operating device (8) and can move relative to the operating element receptacle (9) and from there can be removably positioned, and the operating element (10) has an operating element base (10b) and an operating element cap (10a) covering the operating element base (10b) from above at least in part and which is connected to the operating element base (10b) and can be rotated relative to the operating element base (10b) to adjust operating conditions of the household device (1), **characterised in that** the operating device (8) has at least one adhesive element (42), which is formed on a bottom (24a) of the operating element base (10b), the material of which has a greater frictional resistance than the bottom (24a) of the operating element base (10b).

2. Operating device (8) according to claim 1, **characterised in that** the adhesive element (42) protrudes in a raised manner downwards over the flat bottom (24a).

3. Operating device (8) according to claim 2, **characterised in that** a groove (41) is formed on the bottom (24a), in which the adhesive element (42) is arranged.

4. Operating device (8) according to one of the preceding claims, **characterised in that** the adhesive element (42) is formed as a circumferential ring.

5. Operating device (8) according to one of the preceding claims, **characterised in that** the adhesive element (42) is formed from a liquid silicone.

6. Operating device (8) according to one of the preceding claims, **characterised in that** a receptacle space (39) is formed between the operating element base (10b) and the operating element cap (10a), in which a rotational adjustment device (43) is arranged, which has first rotational adjustment means (44) which are arranged on the operating element base (10b), and has second rotational adjustment means (45) which are arranged on the operating element cap (10a) and are designed to adjust a rotation of the operating element cap (10a) relative to the operating element base (10b) for interaction with the first rotational adjustment means (44).

7. Operating device (8) according to claim 6, **characterised in that** the first rotational adjustment means are magnets (44) which have the same magnetic polarity on the sides facing the second rotational adjustment means formed as magnets (45) as the magnets (45) representing the second rotational adjustment means on the sides facing the magnets (44).

8. Operating device (8) according to claim 6 or 7, **characterised in that** the rotational adjustment device (43) is designed for adjusting a rotational position that can be haptically perceived by a user, in particular a rotational position is designed as a haptically perceivable engagement by touchless interaction of the first and second rotational adjustment means (44, 45).

9. Operating device (8) according to one of claims 6 to 8, **characterised in that** the first rotational adjustment means (44) are arranged in the circumferential direction about an axis of rotation (A) of the operating element cap (10a) and the second rotational adjustment means (45) are arranged in the circumferential direction about the axis of rotation (A), in particular both rotational adjustment means (44, 45) are respectively arranged on a circle with the same radius.

10. Operating device (8) according to claim 9, **characterised in that** viewed in an adjusted rotational position in the direction of the axis of rotation (A) a second rotational adjustment means (45) is arranged circumferentially about the axis of rotation (A) between two first rotational adjustment means (44).

11. Operating device (8) according to one of claims 6 to 10, **characterised in that** the number of the first rotational adjustment means (44) is greater than the number of the second rotational adjustment means (45), in particular two or four second rotational adjustment means (45) are arranged on the operating element cap (10a) and at least 8, in particular at least 10 first rotational adjustment means (44) are arranged on the operating element base (10b).

12. Operating device (8) according to one of the preceding claims, **characterised in that** the operating element cap (10a) and the operating element base (10b) are non-destructively detachably connected.

13. Operating device (8) according to claim 12, **characterised in that** for the at least axial connection and retention of the operating element cap (10a) and the operating element base (10b) a retaining magnet (27, 38) is respectively arranged centrally in each case, in particular the retaining magnet (27) is designed in the operating element base (10b) for magnetic interaction with a central magnet (12) external to the operating element for magnetically retaining the entire operating element (10) on the operating element receptacle (9).

14. Operating device (8) according to one of the preceding claims, **characterised in that** it has an infrared transmit/receive device (17) for selecting a functional subunit (3 to 7) of the household device (1) and which is arranged with transmit/receive units (18) external to the operating element under the operating element base (10b) and is designed for detection through a floor (24) of the operating element base (10b) which is permeable for at least infrared signals.

15. Household device (1) for the preparation of food, in particular a hob (1), having an operating device (8) according to one of the preceding claims.

## Revendications

1. Dispositif de commande (8) pour un appareil ménager (1), comprenant un élément de commande (10) et un logement pour élément de commande (9), dans lequel l'élément de commande (10) est tenable par force magnétique sur le logement pour élément de commande (9) de l'appareil ménager (1) commandable à l'aide du dispositif de commande (8) et déplaçable par rapport au logement pour élément de commande (9) et positionnable afin de pouvoir l'en enlever, et l'élément de commande (10) présente un socle pour élément de commande (10b) et un cache pour élément de commande (10a) couvrant au moins partiellement le socle pour élément de commande (10b) par le dessus, lequel cache est relié au socle pour élément de commande (10b) et rotatif par rapport au socle pour élément de commande (10b) pour le réglage de conditions de fonctionnement de l'appareil ménager (1), **caractérisé en ce que** le dispositif de commande (8) présente au moins un élément adhésif (42) exécuté sur une face inférieure (24a) du socle pour élément de commande (10b), dont le matériau présente une résistance au frottement supérieure à celle de la face inférieure (24a) du socle pour élément de commande (10b).

2. Dispositif de commande (8) selon la revendication 1, **caractérisé en ce que** l'élément adhésif (42) dépasse la face inférieure plane (24a) vers le dessous.

3. Dispositif de commande (8) selon la revendication 2, **caractérisé en ce qu'**une rainure (41) est exécutée sur la face inférieure (24a), dans laquelle l'élément adhésif (42) est disposé.

4. Dispositif de commande (8) selon l'une des revendications précédentes, **caractérisé en ce que** l'élément adhésif (42) est exécuté sous forme de bague périphérique.

5. Dispositif de commande (8) selon l'une des revendications précédentes, **caractérisé en ce que** l'élément adhésif (42) est exécuté en une silicone liquide.

6. Dispositif de commande (8) selon l'une des revendications précédentes, **caractérisé en ce qu'**un espace de logement (39) est exécuté entre le socle pour élément de commande (10b) et le cache pour élément de commande (10a), dans lequel un dispositif de réglage de la position de rotation (43) est disposé, lequel présente de premiers moyens de réglage de la position de rotation (44) disposés sur le socle pour élément de commande (10b) et de deuxièmes moyens de réglage de la position de rotation (45) disposés sur le cache pour élément de commande (10a) et exécutés en vue d'une interaction avec les premiers moyens de réglage de la position de rotation (44) pour le réglage d'une position de rotation du cache pour élément de commande (10a) par rapport au socle pour élément de commande (10b).

7. Dispositif de commande (8) selon la revendication 6, **caractérisé en ce que** les premiers moyens de réglage de la position de rotation sont des aimants (44) présentant, sur les côtés dirigés vers les deuxièmes moyens de réglage de la position de rotation exécutés sous forme d'aimants (45), une polarité magnétique identique à celle que les aimants (45) constituant les deuxièmes moyens de réglage de la position de rotation présentent sur les côtés dirigés vers les aimants (44).

8. Dispositif de commande (8) selon la revendication 6 ou 7, **caractérisé en ce que** le dispositif de réglage de la position de rotation (43) est exécuté en vue du réglage d'une position de rotation perceptible par le toucher pour un utilisateur, en particulier **en ce qu'**une position de rotation est exécutée sous forme d'encliquètement perceptible par le toucher via une interaction sans contact des premiers et deuxièmes moyens de réglage de la position de rotation (44, 45).

9. Dispositif de commande (8) selon l'une des revendications 6 à 8, **caractérisé en ce que** les premiers moyens de réglage de la position de rotation (44) sont, dans le sens périphérique, disposés autour d'un axe de rotation (A) du cache pour élément de commande (10a) et les deuxièmes moyens de réglage de la position de rotation (45) sont, dans le sens périphérique, disposés autour de l'axe de rotation (A), en particulier **en ce que** les deux moyens de réglage de la position de rotation (44, 45) sont respectivement disposés sur un cercle de rayon identique.

10. Dispositif de commande (8) selon la revendication 9, **caractérisé en ce qu'**en présence d'une position de rotation réglée, dans le sens de l'axe de rotation (A), à la périphérie de l'axe de rotation (A), un deuxième moyen de réglage de la position de rotation (45) est disposé entre deux premiers moyens de réglage de la position de rotation (44).

11. Dispositif de commande (8) selon l'une des revendications 6 à 10, **caractérisé en ce que** le nombre de premiers moyens de réglage de la position de rotation (44) est supérieur au nombre de deuxièmes moyens de réglage de la position de rotation (45), en particulier **en ce que** deux ou quatre deuxièmes moyens de réglage de la position de rotation (45) sont disposés sur le cache pour élément de commande (10a) et au moins 8, en particulier au moins 10 premiers moyens de réglage de la position de rotation (44) sont disposés sur le socle pour élément de commande (10b).

12. Dispositif de commande (8) selon l'une des revendications précédentes, **caractérisé en ce que** le cache pour élément de commande (10a) et le socle pour élément de commande (10b) sont reliés de manière amovible non destructive.

13. Dispositif de commande (8) selon la revendication 12, **caractérisé en ce qu'**un aimant de maintien (27, 38) est respectivement disposé au centre en vue de la liaison et du maintien au moins axial du cache pour élément de commande (10a) et du socle pour élément de commande (10b), en particulier **en ce que** l'aimant de maintien (27) est exécuté dans le socle pour élément de commande (10b) en vue de l'interaction magnétique avec un aimant central (12) externe à l'élément de commande pour le maintien magnétique de l'ensemble de l'élément de commande (10) sur le logement pour élément de commande (9).

14. Dispositif de commande (8) selon l'une des revendications précédentes, **caractérisé en ce qu'**il présente un dispositif d'émission-réception infrarouge (17) pour la sélection d'une unité partielle de fonctionnement (3 à 7) de l'appareil ménager (1) disposée avec les unités d'émission-réception (18) à l'extérieur de l'élément de commande sous le socle pour élément de commande (10b) et exécuté pour la détection à travers un fond (24) du socle pour élément de commande (10b) au moins perméable aux signaux infrarouges.

15. Appareil ménager (1) pour la préparation de denrées alimentaires, en particulier champ de cuisson (1) avec un dispositif de commande (8) selon l'une des revendications précédentes.
